# EUROPEAN PATENT APPLICATION

(11) **EP 4 819 483 A1**
(43) Date of publication of application: **07.10.2026**
(21) Application number: 26166963.4
(22) Date of filing: 24.03.2026
(51) Int. Cl.: H02P 31/00, H02P 23/14

(54) **MOTOR IDENTIFICATION AND CONTROL BASED ON CURRENT CHARACTERISTIC RESPONSE**

(30) Priority: 03.04.2025 US 202563783118 P
(71) Applicant: Tesla, Inc., Austin, TX 78725 (US)
(72) Inventor: TAYAL, Shashank, Austin, TX 78725 (US); HORVATIC, Neven, Austin, TX 78725 (US); PRICE, Lanford, Austin, TX 78725 (US)
(74) Representative: Liesegang, Eva

(57) **Abstract**

Systems and methods for enhanced motor identification and control based on current characteristic response. An example method includes injecting voltage into a motor, the motor including a rotor and the voltage being associated with a frequency selected to maintain the rotor to be substantially stationary. A type of the motor is identified based on current characteristics measured in response to the injected voltage. Parameter values associated with the identified type of the motor are accessed, with the controller being configured to trigger operation of the motor in accordance with the parameter values.

## Description

### CROSS-REFERENCE TO RELATED APPLICATIONS

This application claims priority to U.S. Prov. Patent App. No. 63/783118 titled "ENHANCED MOTOR IDENTIFICATION AND CONTROL BASED ON CURRENT CHARACTERISTIC RESPONSE" and filed on April 3, 2025, the disclosure of which is hereby incorporated herein by reference in its entirety.

### BACKGROUND

Modern vehicles include motors to handle, for example, heating, ventilation, and air conditioning (HVAC), radiator fans, and so on. Example motors may include synchronous motors, such as brushless direct current electric motors (BLDC), permanent magnet synchronous motors (PMSM), and so on. The motors may be powered via electric power supplies, such as batteries included in a battery pack.

### SUMMARY

In some embodiments, a method is described. The method is implemented by a controller. The method comprises injecting voltage into a motor, the motor including a rotor and the voltage causing the rotor to be substantially stationary; identifying a type of the motor based on current characteristics measured in response to the injected voltage; and accessing parameter values associated with the identified type of the motor, wherein the parameter values are used in operation of the motor.

In some embodiments, a controller is described. The controller comprises inverter circuitry configured to inject a voltage waveform into a motor at a frequency that maintains a rotor of the motor in a substantially stationary state; current sensing circuitry configured to measure current characteristics of the motor during injection of the voltage waveform, the current characteristics reflecting an inductive property of the motor; and one or more processors configured to: inject, via the inverter circuitry, the voltage waveform into the motor at the frequency; identify a type of the motor from a plurality of types of motors based on current characteristics measured in response to the injected voltage waveform; and access parameter values associated with the identified type of the motor, wherein the controller is configured to trigger operation of the motor in accordance with the parameter values. The controller may be included in a vehicle. The vehicle may include a power source and a motor configured to receive AC power from the controller.

### BRIEF DESCRIPTION OF THE DRAWINGS

The present disclosure is described with reference to the accompanying drawings, in which like reference characters reference like elements, and wherein:
Figure 1A is a block diagram of a vehicle in which an included controller identifies a type of motor based on voltage injection.
Figure 1B is a block diagram illustrating detail of the controller identifying the type of motor.
Figure 2 illustrates example current characteristics associated with voltage injection.
Figure 3 is a flowchart of an example process for identifying a type of motor based on voltage injection techniques as described herein.

### DETAILED DESCRIPTION

This application describes techniques to identify a type of motor, such as a specific motor variant, stock keeping unit (SKU), from a multitude of types of motors based on electrical excitation response characteristics (e.g., voltage response characteristics, generally referred to herein as current characteristics). Example motors may include synchronous motors, such as a brushless direct current electric motor (BLDC). In some embodiments, the motors may be used as parts in a vehicle, such as for heating, ventilation, and air conditioning (HVAC), blowers, coolant pumps, radiator fans, oil pumps, and so on. The identification of a type may be used to rapidly identify, or access, operating parameters for use with a motor.

Example electrical excitation response characteristics may include current characteristics, such as peak current associated with injected voltage. Peak current may include, for example, measured peak current during injection of voltage (e.g., a voltage waveform associated with a frequency greater than a threshold), measured peak current during individual cycles of the voltage injected waveform, and so on. Based on the current characteristics, a controller, processor, and so on (hereinafter controller), may determine, or otherwise identify, that a motor corresponds to a particular type, model, or configuration of motor.

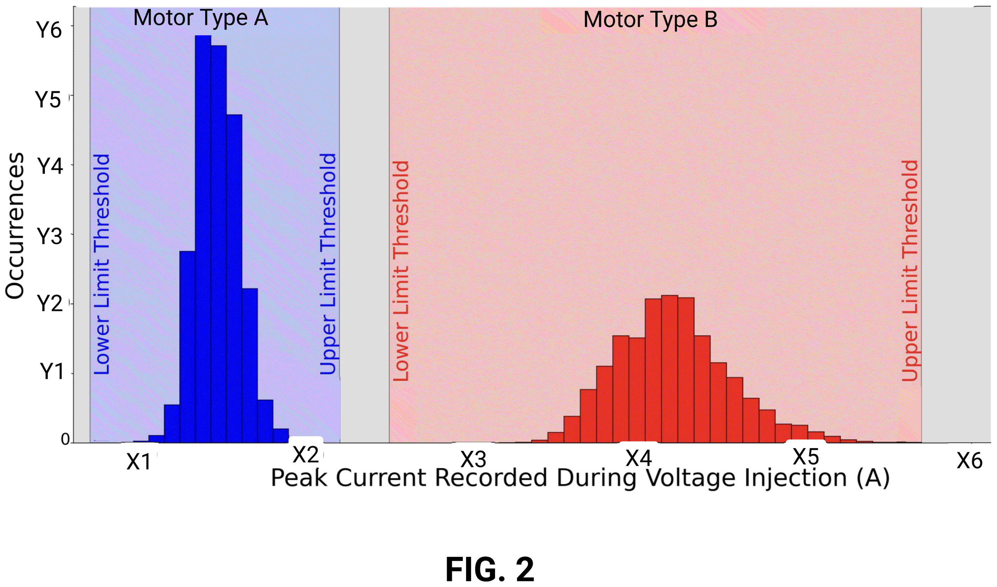

As will be described, and with respect to a BLDC motor, the above-described voltage waveform may cause the rotor to be substantially stationary (e.g., maintained as substantially stationary or stationary) such that current characteristics are dominated by inductive properties of the motor. For example, the rotor may be stationary (e.g., not moving, but not actively held as stationary). The controller may therefore ascertain a specific motor type based on current characteristics due to the measured characteristics correlating with inherent inductive properties of the motor. For example, motors of a same motor type may have similar measured current characteristics (e.g., within a threshold tolerance or tolerances). An example of measured current characteristics for two motor types, although the techniques described herein may distinguish between any number of motor types, is illustrated in Figure 2 and described below.

While peak current is described herein, as may be appreciated, other current characteristics may be used and fall within the scope of the disclosure herein. For example, the controller may determine, or otherwise extract, metrics associated with measured current in response to a voltage injected into, or otherwise applied to, a motor. Example metrics may be based on a time-series analysis of current. Metrics may additionally include measures of central tendency. Metrics may additionally be based on current ranges, current distribution characteristics, and so on. Metrics may additionally be based on use of voltage injected into the motor with different frequencies.

Vehicle manufacturing leverages complicated supply chains in which different types of motors, such as different manufacturers of motors, may be used for a same function in a vehicle. For example, a blower may be included in a model of vehicle. In this example, a vehicle manufacturer may source motors for the blower from different manufacturers. The vehicle manufacturer may also source different types of motors from a same manufacturer. As may be appreciated, these motors may be substantially equivalent in function. However, based on the supply chain, where vehicle manufacturing line locations, and so on, different vehicles of the same model may include different types of motors.

The above-described motors may have different operating characteristics. For example, different controller gains may be used. As another example, different operating points (e.g., optimal operating points, such as combinations of torque and speed) may be used to enable the motors to operate under efficient conditions.

Thus, the motors may require different parameter values (e.g., values of the operating characteristics) to enable efficient operation. An example technique may include programming, or otherwise storing, these different parameter values in controllers used to interface with, or otherwise control, the motors. For example, a first motor type may be used in a particular vehicle. In this example, the controller may receive parameter values corresponding to the first motor type. Thus, an assembly line may be required to identify the specific motor type and cause the inclusion of corresponding parameter values into a controller that corresponds with the specific motor type.

As the complexity of the supply chain increases, the example technique will cause the manufacturing line to slow down. Additionally, incorrect parameter values may cause a motor to work improperly. Furthermore, the vehicle may receive a new motor (e.g., a new or different type) over the course of its life such that updated parameter values may be required. Thus, the techniques described herein may mitigate the burden of tracking motor types to vehicle serial numbers.

In contrast, the techniques described herein enable the controller to determine, or otherwise identify, a specific motor type of a motor controlled by the controller. As may be appreciated, the controller may store parameter values for a multitude of types of motors. During manufacturing the same controller may be used with disparate motors thus simplifying the manufacturing line and improving motor efficiency. During use of the vehicle, the controller may periodically, or based on an action or event (e.g., reboot of the controller), identify the type of motor. Additionally, these parameter values may be updated over the life of the car (e.g., via an over the air update). In this way, even if a motor is replaced with a new motor, the controller may rapidly identify the motor type and access corresponding parameter values.

In this way, the techniques described herein may ease software management (e.g., reduce the need for variants of versions of the controller or software included on the controller). The techniques described herein may additionally decrease manufacturing and multi-source complexity as described herein. Furthermore, the techniques described herein may enable run-time detection in end of line (EOL) manufacturing, service, and vehicle operation.

While the description herein focuses on identifying a type of motor and obtaining corresponding parameter values, in some embodiments the controller, or a different processor, may determine or refine parameter values. For example, the controller may adjust parameter values associated with a type of motor based on the obtained current characteristics. In this way, a vehicle's motor may be further optimized for use in the vehicle.

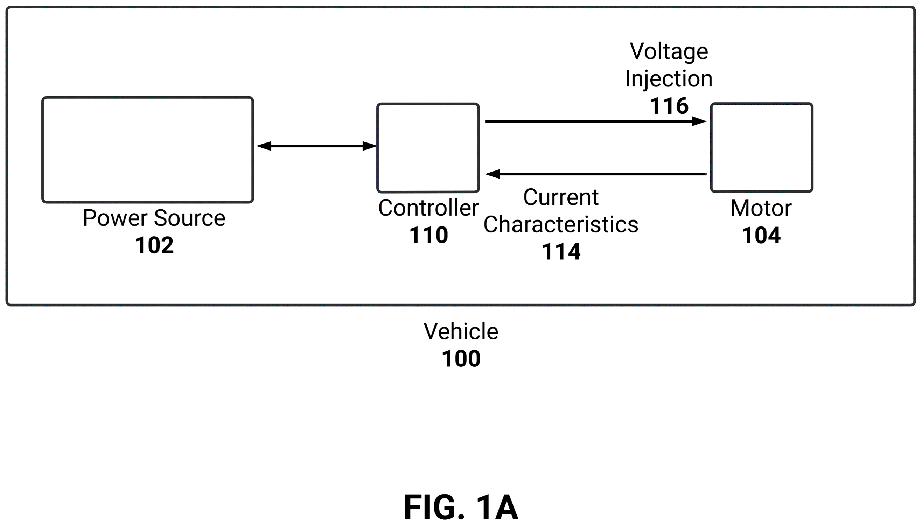

Figure 1A is a block diagram of a vehicle 100 in which an included controller 110 identifies a type of motor 104 based on voltage injection 116. In some embodiments, the vehicle 100 may be an electric vehicle that includes a power source 102. The power source may be, in some embodiments, a battery pack, power supply, and so on. In some embodiments, the vehicle 100 may be an internal combustion engine (ICE) vehicle in which a battery or an alternator is used to generate electricity. As described above, the motor 104 may reflect a synchronous motor in some embodiments (e.g., a brushless DC electric motor).

In the illustrated example, the controller 110 is powered by the power source 102. The controller 110 may, in some embodiments, convert received DC power into AC, for example via inverters of the controller. As described herein, the controller 110 may determine, or otherwise identify, a type of the motor 104. An example type may refer to a manufacturer-specific variant, a stock keeping unit, a winding configuration, a phase winding-to-connector-pin ordering, a pole pair count, a stator geometry, a rotor geometry, a magnet material or grade, or another motor implementation associated with a distinct set of electromagnetic characteristics and set of control parameters.

The controller 110 may include any suitable control hardware that generates the voltage injection 116, measures the current characteristics 114, and determines the type of the motor 104. For example, the controller 110 may include one or more microcontrollers, digital signal processors, field-programmable gate arrays, application-specific integrated circuits, or combinations thereof. The controller 110 may further include inverter circuitry that applies commanded phase voltages to the motor 104, current sensing circuitry that acquires the current characteristics 114, and non-volatile memory that stores identification data, threshold data, and motor-specific parameter values. The controller 110 may execute the identification routine as firmware, software, hardware logic, or a combination thereof.

Example inverter circuitry of the controller 110 may convert DC power received from the power source 102 into multi-phase AC drive signals applied to the motor 104. In some embodiments, the inverter circuitry may include a multi-phase bridge circuit having semiconductor switching devices, such as metal-oxide-semiconductor field-effect transistors, insulated-gate bipolar transistors, silicon carbide transistors, gallium nitride transistors, or other solid-state switching elements arranged in a half-bridge or full-bridge topology corresponding to the phase count of the motor 104. The controller 110 may drive the switching devices via gate driver circuitry that receives pulse-width modulated control signals from the one or more processors and that translates the control signals into gate-level switching commands for the semiconductor switching devices. The inverter circuitry may support space-vector modulation, sinusoidal pulse-width modulation, or another modulation strategy selected by the one or more processors. During the voltage injection 116, the inverter circuitry applies commanded phase voltages according to the injection waveform directed by the one or more processors, and during normal motor operation the inverter circuitry applies drive signals according to the parameter values associated with the identified motor type. In some embodiments, the inverter circuitry includes one or more DC-link capacitors coupled across the DC bus to filter voltage ripple, and one or more temperature sensors coupled to the switching devices or to a heat sink associated with the switching devices.

With respect to determining, or identifying the type of motor 104, and as on example, during manufacturing of the vehicle the controller 110 may execute a routine or instructions to identify the type. The controller 110 may then load, or otherwise obtain, parameter values associated with the type of motor. As another example, during use of the vehicle 100 (e.g., by an owner) the controller 110 may determine, or otherwise identify, the type of motor 104. A service technician may additionally trigger the controller 110 to determine the type of motor. For example, a new motor may be swapped into the vehicle 100. In this example, the controller 110 may identify the type of the new motor such that it can load, or otherwise obtain, corresponding parameter values.

To manage identification over the life of the vehicle 100, the controller 110 may store a most recent identification result in memory and may selectively re-run the identification routine when a triggering event occurs. Example triggering events include initial factory commissioning, a controller reset, entry into a service mode, detection of a motor-related fault, installation of a replacement motor 104, or a mismatch between a stored identification result and a newly measured electrical response. When no triggering event is present, the controller 110 may reuse the stored identification result rather than repeating the identification routine. When the controller 110 confirms the motor type, the controller 110 may transition from an identification mode to a normal run mode and may load the corresponding parameter values for operation of the motor 104. The controller 110 may additionally log the identified motor type together with a time stamp, ignition-cycle count, service-event indicator, or another record for diagnostic, warranty, or fleet-analysis use.

The controller 110 may inject voltage 116 into the motor 104, for example to interrogate its inductance properties. As an example, the controller 110 may apply a rotating voltage vector with known voltage and frequency. The frequency may be greater than, such as at least a threshold greater than, the bandwidth of the mechanical system. Thus, the rotor of the motor 104 may be maintained as stationary or substantially stationary. As known by those skilled in the art, with the rotor not spinning there may be no, or substantially no, back electromagnetic field (EMF). Example frequencies may be between 400 and 800 Hz, 500 and 1000 Hz, and so on. In some embodiments, the controller 110 may start at a first frequency and sweep upwards until determining that the rotor is stationary. For example, the controller 110 may monitor back EMF. As another example, the controller 110 may access rotor position information. Additional techniques may be used and fall within the scope of the disclosure herein.

The voltage injection 116 may include applying a rotating voltage vector having a particular frequency and magnitude to the motor 104. The controller 110 may generate the voltage injection 116, in some embodiments, as a sinusoidal fundamental, a pulse-width modulated approximation of a sinusoidal waveform, a space vector modulated waveform, a stepped phase-voltage waveform, or another commanded waveform that produces a known electrical excitation at the motor 104. Example voltage magnitudes may fall between about 1 V and about 20 V. In some embodiments, the controller 110 may select a magnitude between about 3 V and about 10 V to produce current characteristics 114 with sufficient separation between motor types while limiting torque disturbance and heating. The controller 110 may select the magnitude based on the voltage available from the power source 102, the electrical rating of the motor 104, and the resolution or noise floor associated with measurement of the current characteristics 114.

The controller 110 may select the frequency of the voltage injection 116 such that the rotor of the motor 104 remains substantially stationary during the measurement interval. As an example of substantially stationary, the rotor may not undergo enough angular displacement, speed increase, or back electromotive force generation to materially distort the current characteristics 114 on which the identification is based. The controller 110 may monitor that condition by evaluating back electromotive force, rotor position information, rotor speed information, output of a sensorless estimator, vibration response, or combinations thereof. When the controller 110 detects rotor movement above a threshold, the controller 110 may increase the injection frequency, reduce the injection amplitude, shorten the injection interval, discard the affected measurement, or repeat the routine using a different excitation setting.

In some embodiments, the controller 110 may determine a suitable injection frequency by sweeping the voltage injection 116 across a candidate frequency range while monitoring repeatability and separation of the resulting current characteristics 114. For example, the controller 110 may begin at a frequency on the order of about 500 Hz and may step upward or downward in increments between about 10 Hz and about 100 Hz until the measured response remains stationary and provides adequate distinction between candidate motor types. In some embodiments, the controller 110 may execute the identification routine in a non-saturating mode in which the applied voltage remains low enough that the measured current characteristics 114 primarily reflect a substantially linear inductive response of the motor 104. In some embodiments, the controller 110 may execute the identification routine in a saturation-sensitive mode in which the applied voltage is increased to drive at least part of the magnetic circuit toward saturation, thereby accentuating differences between motor types. The controller 110 may select between the non-saturating mode and the saturation-sensitive mode based on calibration data, expected motor family, available electrical power, or confidence in a prior identification result.

The controller 110 may measure current characteristics 114. In this example, the controller 110 may measure phase current during the voltage injection 116. In some embodiments, the current characteristics 114 may include peak phase current. For example, the peak phase current may reflect peak current during the voltage injection. As another example, the peak phase current may reflect individual peak currents during individual cycles of the voltage injection.

The controller 110 may measure the current characteristics 114 using current sensing circuitry coupled to the motor 104. Example current sensing circuitry may include one or more shunt resistors, Hall-effect sensors, magnetoresistive sensors, current transformers, current mirror-based sensing circuits, or combinations thereof. In some embodiments, the current sensing circuitry may be coupled to one, two, or all three motor phases between the inverter circuitry and the motor 104, or to a DC-link return path shared by multiple phases. The current sensing circuitry may provide an analog signal indicative of instantaneous phase current to one or more analog-to-digital converters of the controller 110, and one or more amplifiers, offset-correction circuits, anti-aliasing filters, or other conditioning circuits may condition the analog signal before digitization.

The controller 110 may sample the measured current at a rate greater than the frequency of the voltage injection 116, such as at least about two times the injection frequency and, in some embodiments, several times the injection frequency, so that the controller 110 can resolve cycle-to-cycle variation and identify a representative current response. To reduce the influence of transient behavior at the start of the voltage injection 116, the controller 110 may ignore one or more initial cycles and may evaluate a later portion of the response after the injected waveform reaches a repeatable state. The controller 110 may additionally filter the measured current using a low-pass filter, a moving-average filter, a band-pass filter centered on the injection frequency, or another filter that suppresses switching noise, sensor offset, or unrelated current components. When the current sensing circuitry measures fewer than all phases, the controller 110 may reconstruct an unmeasured phase current based on a current-summation relationship among the motor phases.

In some embodiments, the controller 110 may derive the current characteristics 114 from multiple injection cycles rather than from a single instantaneous sample. For example, the controller 110 may determine a peak value for each of several cycles and may calculate a mean, median, trimmed mean, mode, or another representative statistic across about 5 to about 500 cycles. The current characteristics 114 may additionally or alternatively include an RMS current value, a current rise time constant, a current decay time constant, a waveform envelope, a standard deviation, a harmonic component, a frequency-domain feature obtained from a fast Fourier transform, or responses measured at multiple injection frequencies. Before identifying the motor type, the controller 110 may normalize the current characteristics 114 for bus voltage, temperature, sensor offset, or other operating conditions so that the comparison to stored identification data remains consistent across different operating states of the vehicle 100.

The controller 110 may determine, or otherwise identify, the type of the motor 104 based on the current characteristics 114. The controller 110 may compare the measured current characteristics 114 to stored identification data for multiple candidate motor types. In some embodiments, the controller 110 may access a lookup table that associates respective lower thresholds and upper thresholds of the current characteristics 114 with corresponding motor types, and the lookup table may define a margin or guard band between adjacent ranges to reduce ambiguous classifications. The controller 110 may additionally or alternatively evaluate one or more decision boundaries, nearest-neighbor relationships, or multi-dimensional feature comparisons when the current characteristics 114 include more than one measured metric or more than one injection condition. The controller 110 may derive the stored thresholds or decision boundaries from calibration data collected across a production population of motors so that the identification accounts for unit-to-unit variation within a given motor type while preserving separation between different motor types. In some embodiments, the controller 110 may calculate a confidence value based on a distance between the measured current characteristics 114 and an adjacent threshold, based on a variance across repeated measurements, or based on agreement between multiple injected test conditions. The controller 110 may accept the identification when the confidence value exceeds a threshold.

In some embodiments, when the measured current characteristics 114 fall outside expected ranges, overlap adjacent ranges, or vary beyond a repeatability threshold, the controller 110 may repeat the voltage injection 116 using a different frequency, a different voltage magnitude, or both. If the controller 110 still does not obtain a sufficiently confident classification, the controller 110 may assign an unknown-type state, store a diagnostic trouble code, select a fallback parameter set with reduced operating limits, or inhibit normal operation of the motor 104 pending service. The controller 110 may scale the identification framework beyond two candidate motor types by storing threshold ranges, feature sets, or model entries for three, five, ten, or more supported motor types and by evaluating the measured current characteristics 114 against each stored candidate set.

Based on the identification, the controller 110 may obtain parameter values associated with operating the motor 104 (e.g., values of operating parameters). Example parameter values may include control parameters such as one or more of feature set usage, start-up sequence, controller gains, motor inductance, motor resistance, motor flux linkage, motor pole pair count, and so on. Example parameter values may include limit parameters, such as one or more of maximum speed, minimum speed, maximum phase current, minimum phase current, maximum phase voltage, minimum phase voltage, maximum temperature, minimum temperature, and so on.

In addition to the parameters described above, the identification of the motor type may enable the controller 110 to resolve differences in how phase windings of the motor 104 are physically assigned to connector pins. Different types of motors may present different phase winding-to-connector-pin assignments at a shared electrical connector interface. For example, a first motor type may map its W, V, and U phase windings to connector pins in a first order. In this example, a second motor type may map the same phase windings to the same connector pins in a different order such that the phase sequence presented at the connector interface of the second motor type is reversed or otherwise permuted relative to the phase sequence of the first motor type. The first motor type and the second motor type may share a connector form factor, pin count, and mechanical mounting configuration, yet differ in the internal routing between each phase winding terminal and the corresponding connector pin. Because, as an example, the controller 110 generates commutation signals according to an assumed phase-to-pin mapping, applying drive signals intended for the first motor type to the second motor type without correcting the phase assignment may result in technical issues. Example technical issues may include incorrect commutation sequencing, reversed or otherwise degraded torque production, elevated acoustic noise, increased vibration, thermal stress on the motor windings, or uncontrolled motor behavior.

The controller 110 may, in some embodiments, thus select a phase mapping configuration corresponding to the identified motor type. The phase mapping configuration may define an association between the drive signal output of the controller 110 and a corresponding phase winding of the motor 104 for that motor type. The controller 110 may access phase mapping configurations for each known motor type (e.g., via memory). In some embodiments, the configurations may be stored as entries within a parameter table indexed by motor type identifier. Upon selecting the phase mapping configuration, the controller 110 routes its drive signal outputs to the phase windings of the motor 104 according to the selected mapping so that commutation sequencing proceeds correctly for the identified motor type. This phase remapping occurs in the signal domain within the controller 110, for example by reordering pulse-width modulation channel assignments or by swapping phase voltage references prior to modulation, and may not require distinct wiring harnesses, additional hardware switches, jumper connections, or manual intervention by a technician. In this manner, the controller 110 may drive any supported motor type through the same physical connector and cable assembly by adjusting the logical assignment of drive signals to connector pins based on the identification result.

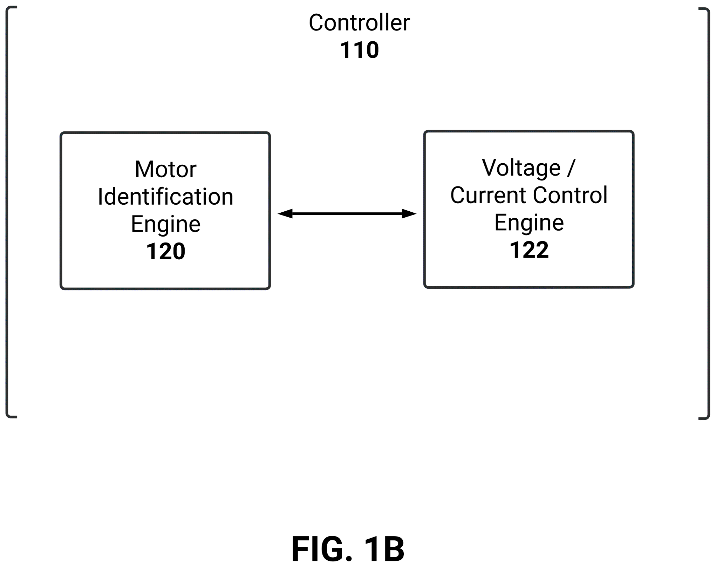

FIG. 1B illustrates a block diagram of the controller 110 identifying a motor type based on current characteristics of a connected motor. The controller 110 includes a motor identification engine 120 and a voltage / current control engine 122 that cooperate to execute an identification routine within the controller 110. The motor identification engine 120 exchanges commands and measurement data with the voltage / current control engine 122 so that the controller 110 can command a test excitation, obtain a resulting current response, and determine the motor type from the measured response. In this arrangement, the voltage / current control engine 122 handles voltage injection and current acquisition, while the motor identification engine 120 handles interpretation of the measured current characteristics and selection of an identification result. The controller 110 may then use the identification result to select operating parameters and phase mapping information, for example as described herein with respect to FIG. 1A.

The voltage / current control engine 122 may inject a known voltage into the connected motor and may measure resulting current characteristics while the rotor remains stationary or substantially stationary. The voltage / current control engine 122 may generate a rotating voltage vector, a direct-axis and quadrature-axis excitation, a pulse-width modulated approximation of a commanded waveform, or another controlled high-frequency excitation that produces a repeatable electrical response. To keep the measured current characteristics dominated by inductive behavior rather than rotor motion, the voltage / current control engine 122 may select an injection frequency greater than the mechanical bandwidth of the motor system, for example on the order of several hundred hertz.

The voltage / current control engine 122 may also adjust injection magnitude, injection duration, or injection frequency responsive to an identification mode or responsive to feedback from the motor identification engine 120. During the measurement interval, the voltage / current control engine 122 may sample phase current at a rate at least about twice the injection frequency, may ignore one or more initial transient cycles, and may filter the measured current using a low-pass filter, a moving-average filter, or a band-pass filter centered on the injection frequency. The voltage / current control engine 122 may provide peak current, RMS current, waveform-shape data, or other current characteristics to the motor identification engine 120.

The motor identification engine 120 may leverage current characteristics obtained while the rotor is stationary or substantially stationary such that speed-dependent terms do not materially distort the identification metric. In one example, the controller 110 may represent direct-axis voltage and quadrature-axis voltage according to the following relationships. ${V}_{d} = {Ri}_{d} + {L}_{d} \frac{{di}_{d}}{dt} - {ω}_{e} {L}_{q} {i}_{q}$ ${V}_{q} = {Ri}_{q} + {L}_{q} \frac{{di}_{q}}{dt} - {ω}_{e} {L}_{d} {i}_{d} + {ω}_{e} {λ}_{pm}$

In these relationships, the controller 110 may use R to denote winding resistance, *i_{d}* and *i_{q}* to denote direct-axis and quadrature-axis currents, *L_{d}* and *L_{q}* to denote direct-axis and quadrature-axis inductances, ω*ₑ* may reflect rotation of the rotor (e.g., electrical speed), and *λₚₘ* to denote permanent-magnet flux linkage.

When the voltage / current control engine 122 applies the high-frequency injection while the rotor remains stationary or substantially stationary. Thus, with high frequency voltage injection this term may be set to zero. The voltage frequency is selected such that the voltage drop across the resistance [*R* _{*} *i_{q}* or *R* _{*} *i_{d}*] is sufficiently small in comparison to the voltage drop across the inductance $\left[{L}_{d}∗\left(\frac{{di}_{d}}{dt}\right)\right.$ or $\left.{L}_{q}∗\left(\frac{dq}{dt}\right)\right]$*.* Therefore, and as may be appreciated, the above-described formulas may be simplified as follows: ${V}_{d} ≅ {L}_{d} \frac{{di}_{d}}{dt}$ ${V}_{q} ≅ {L}_{q} \frac{{di}_{q}}{dt}$ Under this condition, the motor identification engine 120 may identify the motor type from the measured current response without commanding rotor rotation.

In some embodiments, the motor identification engine 120 may estimate one or more inductive properties from the measured current waveform generated in response to the known excitation commanded by the voltage / current control engine 122. For a motor that has not previously been characterized, the motor identification engine 120 may estimate *L_{d}, L_{q},* or an effective inductive value from the measured current waveform. For a motor population that has previously been characterized, the motor identification engine 120 may compare the estimated inductive property, or another extracted current characteristic such as peak current, to stored identification data and may select the motor type that corresponds to the measured response. As described herein, the controller 110 may store the identification data as a lookup table or other mapping that associates ranges of measured response values with corresponding motor types. For example, the motor identification engine 120 may map a measured peak current value to a threshold range associated with a particular motor type. In embodiments in which *L_{d}* and *L_{q}* are similar (e.g., approximately equal, equal, within a threshold) the motor identification engine 120 may identify the motor type based on an effective inductive response, and in embodiments in which *L_{d}* and *L_{q}* differ, the motor identification engine 120 may use direct-axis and quadrature-axis response information as separate identification features.

Using the current characteristics returned by the voltage / current control engine 122, the motor identification engine 120 may compare the measured response to stored identification data associated with multiple motor types. For example, the motor identification engine 120 may evaluate threshold ranges, reference values, lookup entries, or decision boundaries based on more than one measured feature. Responsive to a match between the measured response and stored identification data, the motor identification engine 120 may determine the motor type and may calculate a confidence value based on distance to an adjacent threshold, repeatability across cycles, agreement across multiple injections, or another consistency measure. When the confidence value falls below a threshold, the motor identification engine 120 may instruct the voltage / current control engine 122 to repeat the injection at a different frequency, a different magnitude, or both. When repeated measurements remain outside expected ranges, the controller 110 may classify the connected motor as unknown or may apply a fallback operating set until a valid identification is obtained. The motor identification engine 120 may support two or more candidate motor types by evaluating the measured current characteristics against corresponding stored data for each supported type.

After the motor identification engine 120 identifies the motor type, the controller 110 may use the identification result to select operating parameters for the connected motor. The controller 110 may access a parameter table, a phase mapping configuration, or other calibration data associated with the identified motor type and may load the selected data into an active motor-control routine. In operation, the voltage / current control engine 122 may thereafter drive the connected motor according to the selected calibration, including a selected phase ordering or commutation mapping where appropriate. In some embodiments, the controller 110 may store the identification result in non-volatile memory and may re-run the interaction between the motor identification engine 120 and the voltage / current control engine 122 after a reset, during service, or responsive to detection of a motor-related fault.

Figure 2 illustrates example current characteristics associated with voltage injection. In the illustrated example, current characteristics associated with motor type A and motor type B are included. These current characteristics may reflect measurements across a multitude of motors of each type. On the y-axis, occurrences are indicated reflecting a number of occurrences of a particular peak current. On the x-axis, peak current is indicated. As illustrated, peak currents associated with motor type A are distinct from those of motor type B. A range (e.g., a lower limit threshold and higher limit threshold) may thus be established for each of the motor types. In this way, the above-described controller may measure peak current and determine whether it is between thresholds associated with a motor type. In some embodiments, a motor may be discarded if it falls outside of one of these ranges.

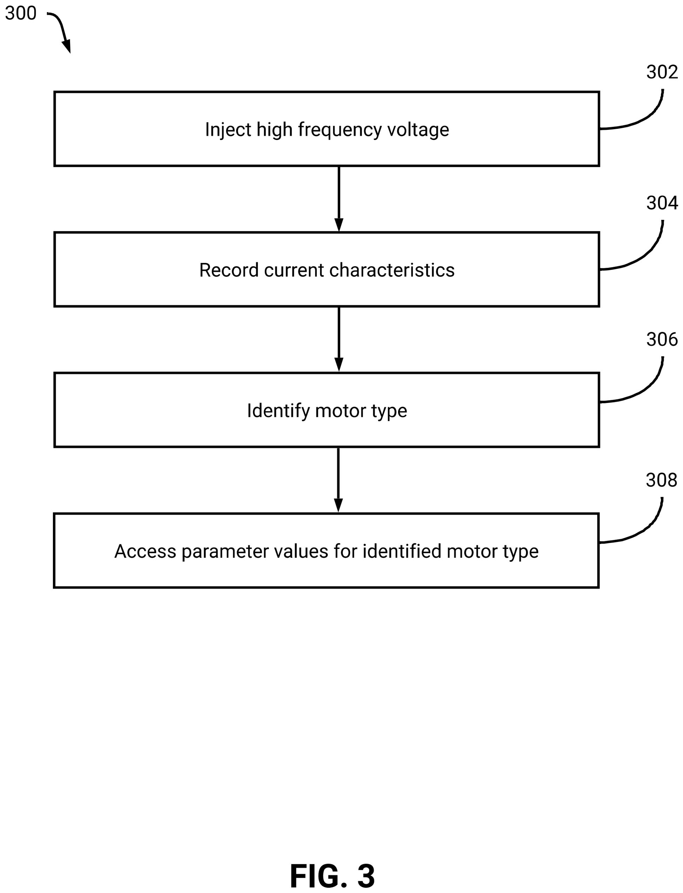

Figure 3 is a flowchart of an example process for identifying a type of motor based on voltage injection techniques as described herein. For convenience, the process 300 will be described as being performed by a controller (e.g., controller 110).

At block 302, the controller injects voltage, such as high frequency voltage, into a motor. As one example, this may cause inductance saturation. In some embodiments, this may not cause inductance saturation. As described above, the motor's rotor may be stationary or substantially stationary. At block 304, the controller records current characteristics. At block 306, the controller identifies a type of the motor. With respect to the current characteristics being peak current, the controller may identify whether the peak current is within a range of currents known to be associated with a particular type of motor. At block 308, the controller accesses parameter values for use in operating the motor.

At block 302, the system injects high frequency voltage into the motor. The system may apply the high frequency voltage as a rotating voltage vector having a known voltage magnitude and a known frequency. The system may select the frequency such that the frequency remains much greater than a bandwidth of the mechanical system, thereby keeping the rotor stationary or substantially stationary during the injection interval. Under that condition, the resulting current is dominated by an inductive property of the motor. In some embodiments, the high frequency voltage causes inductance saturation, although in other embodiments the high frequency voltage does not cause inductance saturation.

At block 304, the system records current characteristics during the high frequency voltage injected at block 302. The current characteristics may include peak current, such as peak phase current recorded during the voltage injection. The system may record the current characteristics while the rotor remains stationary or substantially stationary so that the recorded response corresponds to the known injection condition rather than to driven rotation of the motor. When the system selects the injection frequency appropriately, the recorded current characteristics directly correlate to the motor's inductive property.

At block 306, the system identifies motor type based on the current characteristics recorded at block 304. With respect to the current characteristics being peak current, the system may determine whether the measured peak current falls within a range of currents known to be associated with a particular type of motor. The system may therefore distinguish between different motor types by comparing the measured current response produced under the known high frequency voltage of block 302 to previously established current ranges. In this manner, the system identifies motor type from an electrical response that reflects an inductive behavior of the motor.

At block 308, the system accesses parameter values for identified motor type. The parameter values may include values used in operating the motor after the identification at block 306. The system may access the parameter values from stored data that associates motor types with corresponding operating data and may thereafter use the accessed parameter values to control the motor according to the identified motor type.

The system may then implement the accessed parameter values in an active motor-control routine. For example, the system may load controller gains, phase mapping information, commutation sequencing data, start-up sequence data, pulse-width modulation settings, field weakening thresholds, and operating limits associated with the identified motor type into working memory used by the drive routine. Based on loading or accessing the parameter values, the system may transition from an identification mode to a normal run mode and may drive the motor according to the selected calibration.

During subsequent operation, the system may apply the accessed parameter values to start-up control, steady-state speed control, torque production, fault monitoring, and limit enforcement for the identified motor type. For example, the system may use a selected phase mapping to align controller outputs with phase windings of the identified motor, may apply gains associated with that motor type, and may enforce current, voltage, temperature, or speed limits associated with that motor type. If the resulting motor response indicates that the selected parameter values are no longer appropriate, such as after a controller reset, a service event, replacement of the motor, or detection of a mismatch between expected and measured response, the system may re-execute process 300 and may update the active parameter values based on a new identification result. The system may additionally store the identification result and an indication of the active parameter set in memory for later startup, diagnostics, service, warranty, or fleet-analysis use.

In some embodiments, the system executes process 300 for a motor used in a vehicle subsystem, such as a heating, ventilation, and air conditioning blower, a coolant pump, a radiator fan, or an oil pump. The same process 300 may also be used for other electrically driven blower, fan, or pump applications in which different motor types share a common controller interface but use different operating parameters. By identifying the motor type and then applying the corresponding parameter values in operation, the system may control different supported motor variants through a common controller architecture during factory commissioning, in-vehicle use, and service.

### Additional Embodiments

It is to be understood that not necessarily all objects or advantages may be achieved in accordance with any particular embodiment described herein. Thus, for example, those skilled in the art will recognize that certain embodiments may be configured to operate in a manner that achieves or optimizes one advantage or group of advantages as taught herein without necessarily achieving other objects or advantages as may be taught or suggested herein.

All of the processes described herein may be fully automated via software code modules, including one or more specific computer-executable instructions executed by a computing system. The computing system may include one or more computers or processors. The code modules may be stored in any type of non-transitory computer-readable medium or other computer storage device. Some or all the methods may be embodied in specialized computer hardware.

Many other variations than those described herein will be apparent from this disclosure. For example, depending on the embodiment, certain acts, events, or functions of any of the processes described herein can be performed in a different sequence, can be added, merged, or left out altogether (e.g., not all described acts or events are necessary for the practice of the processes). Moreover, in certain embodiments, acts or events can be performed concurrently, e.g., through multi-threaded processing, interrupt processing, or multiple processors or processor cores or on other parallel architectures, rather than sequentially. In addition, different tasks or processes can be performed by different machines and/or computing systems that can function together.

The various illustrative logical blocks and modules described in connection with the embodiments disclosed herein can be implemented or performed by a machine, such as a processing unit or processor, a digital signal processor (DSP), an application specific integrated circuit (ASIC), a field programmable gate array (FPGA) or other programmable logic device, discrete gate or transistor logic, discrete hardware components, or any combination thereof designed to perform the functions described herein. A processor can be a microprocessor, but in the alternative, the processor can be a controller, microcontroller, or state machine, combinations of the same, or the like. A processor can include electrical circuitry configured to process computer-executable instructions. In another embodiment, a processor includes an FPGA or other programmable device that performs logic operations without processing computer-executable instructions. A processor can also be implemented as a combination of external computing devices, e.g., a combination of a DSP and a microprocessor, a plurality of microprocessors, one or more microprocessors in conjunction with a DSP core, or any other such configuration. Although described herein primarily with respect to digital technology, a processor may also include primarily analog components. A computing environment can include any type of computer system, including, but not limited to, a computer system based on a microprocessor, a mainframe computer, a digital signal processor, a portable external computing device, a device controller, or a computational engine within an appliance, to be name a few.

Conditional language such as, among others, "can," "could," "might," or "may," unless specifically stated otherwise, are otherwise understood within the context as used in general to convey that certain embodiments include, while other embodiments do not include, certain features, elements and/or steps. Thus, such conditional language is not generally intended to imply that features, elements and/or steps are in any way required for one or more embodiments or that one or more embodiments necessarily include logic for deciding, with or without user input or prompting, whether these features, elements and/or steps are included or are to be performed in any particular embodiment.

Disjunctive language such as the phrase "at least one of X, Y, or Z," unless specifically stated otherwise, is otherwise understood with the context as used in general to present that an item, term, etc., may be either X, Y, or Z, or any combination thereof (e.g., X, Y, and/or Z). Thus, such disjunctive language is not generally intended to, and should not, imply that certain embodiments require at least one of X, at least one of Y, or at least one of Z to each be present.

Any process descriptions, elements or blocks in the flow diagrams described herein and/or depicted in the attached figures should be understood as potentially representing modules, segments, or portions of code that include one or more executable instructions for implementing specific logical functions or elements in the process. Alternate implementations are included within the scope of the embodiments described herein in which elements or functions may be deleted, executed out of order from that shown, or discussed, including substantially concurrently or in reverse order, depending on the functionality involved as would be understood by those skilled in the art.

Unless otherwise explicitly stated, articles such as "a" or "an" should generally be interpreted to include one or more described items. Accordingly, phrases such as "a device configured to" are intended to include one or more recited devices. Such one or more recited devices can also be collectively configured to carry out the stated recitations. For example, "a processor configured to carry out recitations A, B, and C" can include a first processor configured to carry out recitation A working in conjunction with a second processor configured to carry out recitations B and C.

## Claims

1. A method implemented by a controller, the method comprising:
injecting voltage into a motor, the motor including a rotor and the voltage being associated with a frequency selected to maintain the rotor to be substantially stationary;
identifying a type of the motor from a plurality of types of motors based on current characteristics measured in response to the injected voltage; and
accessing parameter values associated with the identified type of the motor,
wherein the controller is configured to trigger operation of the motor in accordance with the parameter values, preferably wherein the controller is included in a vehicle, and wherein the motor is associated with heating, ventilation, and air conditioning (HVAC).

2. The method of claim 1, wherein the frequency is greater than a mechanical bandwidth of a mechanical system that includes the motor such that the rotor remains substantially stationary during the injecting.

3. The method of one of the preceding claims, wherein the injected voltage causes inductance saturation, such that a current response of the motor is dominated by an inductive property of the motor.

4. The method of one of the preceding claims, wherein the current characteristics reflect peak current, preferably wherein identifying a type of the motor is based on the peak current being within a range associated with the type of the motor.

5. The method of one of the preceding claims, wherein the current characteristics are measured over a plurality of cycles associated with the voltage.

6. The method of one of the preceding claims, wherein parameter values include control parameters and/or limit parameters; and/or wherein parameter values reflect gain and/or operating point.

7. The method of claim 6, wherein the control parameters comprise at least one of feature set usage, start-up sequence, controller gains, motor inductance, motor resistance, motor flux linkage, or motor pole pair count associated with the identified type of the motor.

8. The method of claim 6 or 7, wherein the limit parameters comprise at least one of maximum speed, minimum speed, maximum phase current, minimum phase current, maximum phase voltage, minimum phase voltage, maximum temperature, or minimum temperature associated with the identified type of the motor.

9. The method of one of the preceding claims, further comprising determining a confidence value associated with the identified type based on the measured current characteristics, and responsive to the confidence value being below a confidence threshold, repeating the injecting at a different frequency or voltage magnitude.

10. A controller comprising:
inverter circuitry configured to inject a voltage waveform into a motor at a frequency that maintains a rotor of the motor in a substantially stationary state;
current sensing circuitry configured to measure current characteristics of the motor during injection of the voltage waveform, the current characteristics reflecting an inductive property of the motor; and
one or more processors configured to:
inject, via the inverter circuitry, the voltage waveform into the motor at the frequency;
identify a type of the motor from a plurality of types of motors based on current characteristics measured in response to the injected voltage waveform; and
access parameter values associated with the identified type of the motor, wherein the controller is configured to trigger operation of the motor in accordance with the parameter values.

11. The controller of claim 10, wherein identifying a type of the motor is based on peak current indicated via the current characteristics as being within a range associated with the type of the motor.

12. The controller of claim 10 or 11, wherein to access the parameter values the one or more processors are configured to access a lookup table associating individual types of motors with a lower threshold value and an upper threshold value defining a range of expected peak current, and/or wherein the parameter values include phase mapping information, and wherein the one or more processors select a phase winding mapping for the motor based on the identified type.

13. A vehicle comprising:
a power source;
the controller recited in one of claims 10 to 12, wherein the controller is configured to receive DC power from the power source; and
a motor configured to receive AC power from the controller.

14. The vehicle of claim 13, wherein the motor is a DC brushless electric motor, and/or wherein the motor is configured for use in one or more of heating, ventilation, and air conditioning (HVAC), a blower, a coolant pump, or a radiator fan.

15. The vehicle of claim 13 or 14, wherein the controller stores the identified type in non-volatile memory and re-executes the identification responsive to a trigger event.
